Europäisches Patentamt

European Patent Office

Office européen des brevets

(19)

(11) Numéro de publication: **0 059 653**
**B1**

(12) **FASCICULE DE BREVET EUROPEEN**

(45) Date de publication du fascicule du brevet:
10.10.84

(51) Int. Cl.³: **F 24 J 3/02, H 01 L 31/02**

(21) Numéro de dépôt: 82400221.6

(22) Date de dépôt: **08.02.82**

(54) Miroir concave constitué d'une pluralité de facettes planes et générateur solaire comportant un tel miroir.

(30) Priorité: **20.02.81 FR 8103409**

(43) Date de publication de la demande:
**08.09.82 Bulletin 82/36**

(45) Mention de la délivrance du brevet:
**10.10.84 Bulletin 84/41**

(84) Etats contractants désignés:
**BE CH DE GB IT LI NL SE**

(56) Documents cités:
**GB - A - 2 054 829**
**US - A - 2 987 961**
**US - A - 3 713 727**
**US - A - 4 192 289**

**THE REVIEW OF SCIENTIFIC INSTRUMENTS, vol.25,
no.5, mai 1954, New York (US), R. GARDON."A
Segmented-Mirror Solar Furnace for High-Intensity
Thermal Radiation Studies", pages 459-463**

(73) Titulaire: **Société Nationale Industrielle Aérospatiale
Société anonyme dite:, 37 Bld de Montmorency,
F-75016 Paris (FR)**

(72) Inventeur: **Girard, Alain, 18 rue des Orangers,
F-06170 Cros de Cagnes (FR)**

(74) Mandataire: **Bonnetat, Christian et al, Cabinet PROPI
Conseils 23 rue de Léningrad, F-75008 Paris (FR)**

## Description

La présente invention concerne un miroir concave constitué d'une pluralité de facettes planes. Elle se rapporte également à un générateur solaire comportant un tel miroir.

On sait que, notamment en vue de la production d'énergie à partir du soleil, on utilise des concentrateurs, par exemple constitués de miroirs concaves, de grandes dimensions, de forme par exemple sphérique ou parabolique.

Afin de pouvoir construire aisément, à des coûts non prohibitifs, de tels miroirs concaves de grandes dimensions, on a déjà proposé de réaliser ceux-ci à l'aide d'une pluralité de facettes réfléchissantes individuelles. Ainsi, par exemple, dans les documents US-A-2 987 961 et US-A-3 009 391, on décrit des miroirs concaves constitués d'une pluralité de facettes sphériques, tandis que les documents US-A-3 494 231 et US-A-3 645 606 décrivent des miroirs paraboliques formés par la juxtaposition d'une pluralité de facettes paraboliques.

Les méthodes révélées dans les brevets précités permettant bien de faciliter la construction de miroirs concaves; cependant, elles présentent l'inconvénient de devoir utiliser des facettes conformées en portions de sphère ou de paraboloïde.

Pour éviter cet inconvénient, on a déjà proposé de construire des miroirs concaves au moyen d'une pluralité de facettes réfléchiss antes planes; des exemples de tels miroirs étant donnés par exemple par les documents US-A-2 760 920 et US-A-3 713 727. Cependant, l'approximation de la surface continue parabolique ou sphérique d'un miroir concave par une surface multifacettes obtenue par la juxtaposition d'une multitude de facettes planes individuelles confère à la surface réfléchissante multifacettes des propriétés optiques de réflexion quelque peu différentes de celles présentées par ladite surface continue.

Pour tenter de réduire le plus possible ces différences de propriétés réfléchissantes, l'auteur du document US-A-2 760 920 »utilise une surface parabolique qui est couverte ou tapissée de petits miroirs plans . . . et, à cause de la petitesse des miroirs, les réflexions individuelles sont focalisées de façon appropriée pour pouvoir être par un absorbeur disposé au-dessus du réflecteur«. Ainsi, selon ce document US-A-2 760 920, pour approcher au mieux les propriétés optiques de la surface concave continue idéale que l'on cherche à reconstituer au moyen de facettes planes, on utilise un très grand nombre de facettes planes de très petites dimensions. Cette méthode permet certainement d'obtenir des propriétés réfléchissantes très proches de celles du miroir concave continu, mais en revanche elle est difficile et coûteuse à mettre en oeuvre à cause de la petitesse et du grand nombre des facettes réfléchissantes individuelles.

Dans le dispositif décrit dans le document US-A-3 713 727, le problème de l'approximation d'une surface réfléchissante concave continue par une surface réfléchissante concave à facettes planes est résolu de façon différente. L'auteur de ce brevet détermine, dans le plan focal de la surface multifacettes, la forme (carrée ou rectangulaire) et les dimensions de la tache focale utile désirée et il adapte la forme et les dimensions des facettes réfléchissantes, pour que le faisceau réfléchi par chacune desdites facettes réfléchissantes donne, dans le plan focal de la surface multifacettes, une tache recouvrant totalement ou partiellement ladite tache focale utile. Bien entendu, notamment dans le cas où le faisceau réfléchi par chaque facette recouvre totalement la surface de la tache focale désirée, il est indispensable, pour utiliser au maximum la surface réfléchissante multifacettes et éviter qu'une partie du rayonnement qu'elle réfléchit ne soit systématiquement inutilisée car donnant dans le plan focal de la surface réfléchissante une tache débordant la tache focale utile désirée, d'adapter les dimensions de chaque facette en fonction de l'éloignement de celle-ci de l'axe de la surface réfléchissante.

Dans le document US-A-3 713 727, il est à cet effet précisé que les dimensions des facettes réfléchissantes sont d'autant plus petites que ces facettes sont plus éloignées de l'axe du miroir. Ainsi, dans ce dernier brevet américain, chaque facette présente ses propes dimensions, de sorte que la fabrication d'un tel miroir multifacettes reste long et onéreux.

Par ailleurs, les documents US-A-4 192 289 et GB-A-2 054 829 décrivent des miroirs concaves réalisés au moyen de facettes rectangulaires ou carrées planes, mais ils n'indiquent pas de moyens pour éviter les inconvénients mentionnés ci-dessus, dus à l'approximation d'une surface par des facettes planes.

L'objet de la présente invention est précisément d'éliminer les difficultés provenant de cette approximation, dans un miroir multifacettes dans lequel toutes les facettes sont identiques.

A cette fin, selon l'invention, le miroir concave qui, d'une part, est destiné à fournir, lorsqu'il est pointé vers une source lumineuse éloignée,tel que le soleil, une tache focale ou quasi-focale utile de forme approximativement carrée ou rectangulaire de dimensions prédéterminées, ladite tache utile étant centrée sur l'axe dudit miroir et dont, d'autre part, la surface réfléchissante est constituée d'une pluralité de facettes planes dont la forme et les dimensions correspondent à celles de ladite tache utile et qui sont disposées en lignes et colonnes, de sorte que la section, dans le plan de la tache utile, du faisceau réfléchi provenant de chaque facette plane recouvre totalement ladite tache utile, est remarquable en ce toutes les facettes sont identiques et en ce que les deux dimensions desdites facettes sont telles que la racine carrée de leur produit est au moins approximativement égale au rapport de la distance focale du miroir et de la racine carrée du taux de concentration de celui-ci.

La Demanderesse a en effet trouvé empiriquement qu'en liant les dimensions des facettes, la distance focale du miroir et le taux de concentration de celui-ci (c'est-à-dire pratiquement le nombre des facettes), on obtenait un compromis acceptable entre la surface inutilisée de chaque facette en fonction de la position de celle-ci sur le miroir et la zone de pénombre de la tache utile.

On remarquere que l'article »A Segmented-Mirror Solar Furnace for High-Intensity Thermal Radiation Studies« paru dans la revue THE REVIEW OF SCIENTIFIC INSTRUMENTS, vol. 25, n°5, mai 1954, New York, (US), R. GARDON, décrit un miroir à facettes et il est précisé que le nombre C des facettes est égal à 400, que la surface $d_1 \cdot d_2$ est égale à 3 square in. (19,35 cm$^2$) et que la distance focale F est égale à 7 ft. 6 in. (228,6 cm).

La relation

$$\sqrt{d_1 \cdot d_2} = \frac{F}{\sqrt{C}}$$

conforme à l'invention n'y est pas respectée.

En effet, $\sqrt{d_1 \cdot d_2} = \sqrt{19,35} = 4,39,$ alors que

$$\frac{F}{\sqrt{C}} = \frac{228,6}{\sqrt{400}} = \frac{228,6}{20} = 11,43 \, .$$

Le miroir décrit dans ledit article ne satisfait donc pas à la caractéristique principale de l'invention et ne peut donc bénéficier des avantages du miroir selon l'invention.

Dans le cas particulier où les facettes réfléchissantes planes du miroir selon l'invention sont carrées, chacun de leurs côtés a une longueur telle qu'elle est au moins approximativement égale au rapport de la distance focale du miroir et de la racine carrée du taux de concentration dudit miroir.

De préférence, chaque facette présente des dimensions sensiblement égales à celles de la tache utile et, dans les lignes et les colonnes, les facettes individuelles sont tournées, dans leur plan, et autour de leur centre, pour que la section, dans le plan de la tache utile, du faisceau réfléchi par chacune d'elles recouvre totalement ladite tache utile, l'amplitude de cette rotation étant d'autant plus grande que la facette est plus éloignée du sommet du miroir. Dans la description en regard des figures seront données des formules empiriques pour placer les coins desdites facettes.

Ainsi, grâce à cette autre particularité, on peut faire en sorte que toutes les taches lumineuses émises par lesdites facettes recouvrent complètement ladite tache utile, même si les dimensions des facettes sont très proches de celles de la tache utile.

On remarquera que, dans le miroir selon l'invention, le faisceau réfléchi global est uniforme. En effet, ce faisceau réfléchi global est la somme des faisceaux individuels réfléchis par chacune des facettes planes; or, chacun de ces faisceaux réfléchis est bien entendu uniforme, de sorte qu'il en est de même du faisceau réfléchi global.

Il en résulte que le miroir selon l'invention est particulièrement approprié à être utilisé, comme concentrateur, dans un générateur solaire comportant un ensemble de cellules photovoltaïques.

En effet, on sait qu'une cellule photovoltaïque engendre, sous faible tension, un courant électrique, dont l'intensité est sensiblement proportionelle à l'éclairement. Sous flux solaire concentré, cette intensité peut atteindre plusieurs ampères par cm$^2$.

Ainsi, dans un générateur photovoltaïque, il est indispensable de disposer de nombreuses cellules photovoltaïques en série pour obtenir la puissance électrique engendrée sous tension et intensité raisonnables. Cependant, une chaîne de cellules photovoltaïques en série fournit un courant dont l'intensité est égale à celle de la plus mauvaise cellule, ou de la cellule la moins éclairée. Il est donc fondamental d'éclairer une chaîne de cellules photovoltaïques en série de façon uniforme, ainsi d'ailleurs que de maintenir lesdites cellules à des températures égales.

Les panneaux plans de cellules photovoltaïques dirigés vers le soleil reçoivent un éclairement uniforme sur toutes les cellules; toutefois, pour obtenir une puissance electrique raisonnable avec de tels panneaux plans, éclairés directement par le soleil, il est indispensable de prévoir sur ceux-ci un grand nombre de cellules. Etant donné le prix élevé de celles-ci, il est donc préférable, pour une même puissance désirée, d'utiliser un concentrateur solaire permettant de réduire la surface desdites cellules, à condition que ledit concentrateur fournisse un flux uniforme, comme le miroir de l'invention.

Ainsi, un générateur solaire comportant d'une part un concentrateur solaire et d'autre part un agencement de cellules photovoltaïques sera remarquable, selon l'invention, en ce que ledit concentrateur solaire est constitué par le miroir de l'invention, mentionné ci-dessus, et en ce que la face sensible dudit agencement de cellules photovoltaïque correspond au moins approximativement, en forme et en dimensions à ladite tache focale ou quasi-focale utile et est mise en superposition avec celle-ci.

Dans le générateur selon l'invention, on doit donc maintenir ledit agencement de cellules photovoltaïques au voisinage du foyer du miroir. Ceci peut être réalisé de façon connue au moyen de bras convergents prenant appui à la périphérie du miroir et supportant ledit agencement de cellules photovoltaïques. Cependant, un tel système de bras de support et d'agencement de cellules photovoltaïques présente l'inconvénient de porter une ombre sur le miroir.

A ce propos, on remarquera que, dans un générateur solaire photovoltaïque à miroir concentrateur, toute ombre portée sur le miroir entraîne l'occultation des cellules photovoltaïques correspondantes. Etant donné le montage en série de celles-ci, il en résulte que chaque cellule doit être protégée par une diode de protection en parallèle, pour éviter que, en cas d'occultation, les autres cellules photovoltaïques puissent débiter en sens inverse à travers elle, ce qui se traduit par une diminution du rendement électrique et une complication globale du générateur et des appareils qu'il alimente qui doivent s'accommoder de variations de tension importantes.

En revanche, dans le générateur photovoltaïque selon l'invention, en cas d'ombre portée accidentellement sur une ou plusieurs facettes du miroir, le flux lumineux sur les cellules photovoltaïques reste uniforme, bien que plus faible, du fait de la structure dudit moroir. Toutes les cellules continuent de fonctionner de la même manière: l'intensité débitée est plus faible, mais la tension ne varie pas ou très peu. Il devient possible d'éliminer la majorité des diodes de protection, ce qui se traduit par une augmentation du rendement électrique et une simplification globale du générateur.

Par ailleurs, selon une caractéristique du générateur selon l'invention, les zones du miroir correspondant aux zones d'ombre systématique portée par les bras du support de l'agencement de cellules photovoltaïques et/ou par agencement, lorsque l'axe du miroir est pointé vers le soleil, ne sont pas réfléchissantes. On élimine ainsi le problème des ombres portées par la structure de support de l'agencement des cellules photovoltaïques.

Les figures du dessin annexé feront bien comprendre comment l'invention peut être réalisée.

La figure 1 est une vue de l'avant partielle, en perspective, d'un générateur solaire comportant un miroir selon l'invention.

La figure 2 est une vue de l'arrière partielle, en perspective, du générateur solaire de la figure 1.

La figure 3 est une vue schématique de la surface réfléchissante du miroir du générateur des figures 1 et 2, en projection parallèlement à l'axe dudit miroir.

La figure 4 est un schéma optique faisant apparaître la portion utile d'une facette en fonction de sa position.

La figure 5 montre, en vue schématique, le huitième de la surface réfléchissante du miroir selon l'invention, en projection parallèlement à l'axe dudit miroir, la rotation des facettes dans leur plan étant exagérée à des fins de clarté.

La figure 6 montre des systèmes d'axes de référence servant à définir la rotation des facettes dans leur plan.

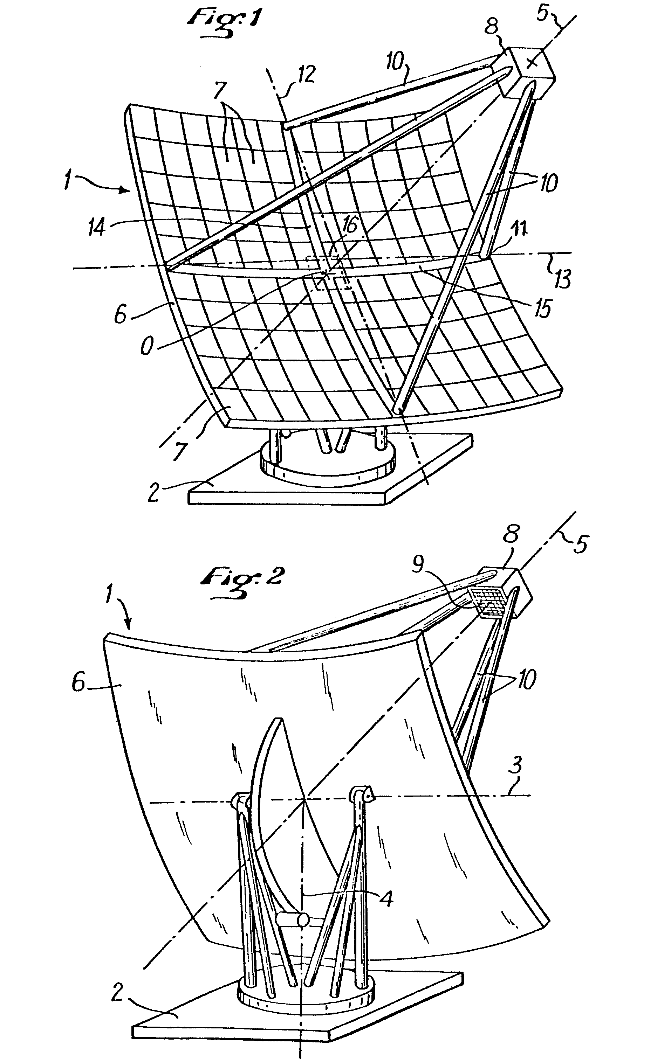

Le générateur solaire photovoltaïque selon l'invention, montré par les figures 1 et 2, comporte un miroir concave 1, mobile par rapport à un socle 2. Grâce à des moyens partiellement représsentés, le miroir 1 peut être asservi en position autour d'un axe 3 d'asservissement en site et d'un axe vertical 4 d'asservissement en azimut, de façon que son axe 5 soit constamment orienté vers le soleil.

Le miroir concave 1 est constitué d'un support rigide concave 6, sur lequel sont fixées des facettes planes 7 identiques, par exemple rectangulaires ou carrées. Le support rigide 6 peut être de toute nature, par exemple être réalisé par une structure en nid d'abeilles ou en treillis. Sa forme peut être sphérique, parabolique, cylindro-parabolique, etc... Cependant, on préfère que le support rigide présente la forme d'un paraboloïde de révolution, de sommet 0 et d'axe 5. Les facettes 7 sont fixées sur le support 6 par tout moyen connu, par exemple par collage ou bien par l'intermédiaire d'une articulation (non représentée).

Un bloc de cellules photovoltaïques 8 est prévu au voisinage du foyer du miroir 1, de façon que sa face sensible 9 soit centrée par rapport à l'axe 5 et dirigée vers les facettes 7. La forme (carrée ou rectangulaire) et les dimensions de la face sensible 9 du bloc 8 sont sensiblement identiques à celles des facettes 7.

Le bloc 8 est supporté par quatre bras 10 solidaires du miroir 1, à sa périphérie. Les bras 10 se trouvent, par paire, dans deux plans de symétrie orthogonaux du support 6. Ainsi, les pieds 11 d'attache des bras 10 au miroir 1 se trouvent deux à deux sur deux axes rectangulaires 12 et 13. Ces bras 10 servent au passage de canalisations électriques et hydrauliques reliant le bloc 8 à des dispositifs (non repésentés) extérieurs au générateur solaire.

Le contour extérieur du miroir 1 présente la forme d'un rectangle ou d'un carré, à côtés curvilignes, deux desdits côtés étant de direction génerale parallèle à l'axe 12 et les deux autres à l'axe 13.

Les facettes réfléchissantes 7, qui peuvent être de toute nature désirée (métalliques, verre argenté, etc...) sont réparties en quatre groupes identiques comportant chacun n × m facettes réparties en n lignes et m colonnes. Dans chaque groupe de facettes 7, les n lignes sont parallèles à l'axe 13 et les m colonnes à l'axe 12. Dans l'exemple représenté, n et m ont respectivement été choisis à 5 et 6. Les quatre groupes de facettes 7 sont séparés les uns des autres par deux zones linéaires 14 et 15, formant une croix passant par le centre du miroir 1 et correspondant aux ombres portées par les quatre bras 10, lorsque l'axe 5 est pointé vers le soleil.

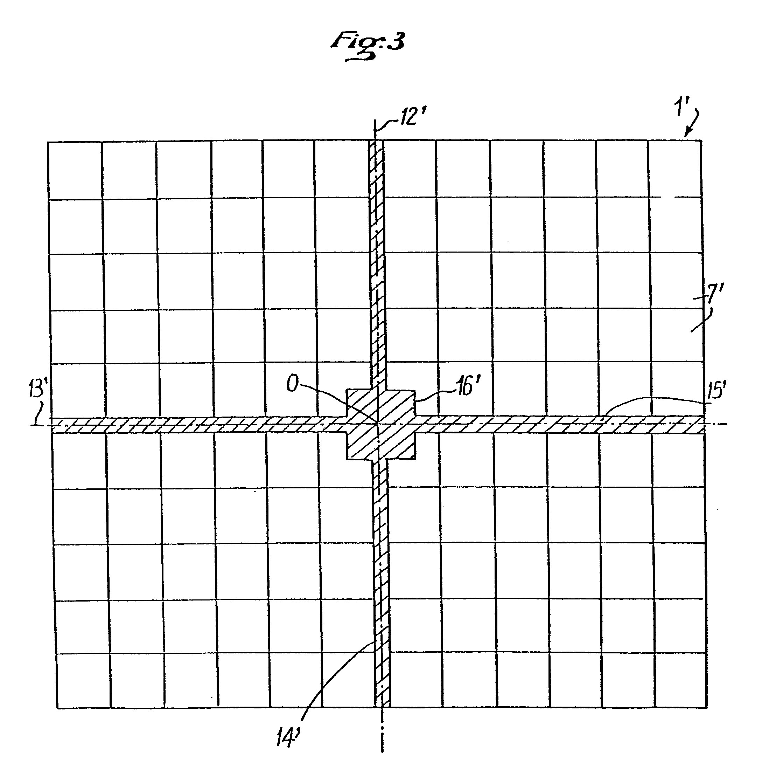

Sur la figure 3, on a représenté la distribution des facettes 7, vue en projection sur un plan orthogonal à l'axe 5 et passant par le sommet O du paraboloïde. Sur cette figure 3, les projections des différents éléments de la figure 1 sont respectivement affectés d'un indice prime.

Dans l'exemple représenté la zone d'ombre 16 (16' en projection sur la figure 3) du bloc focal 8 couvre quatre quarts des quatre facettes 7 entourant directement le sommet O. Il est facile de voir que ces quatre quarts ne correspondent pas à quatre facettes, mais à une seule effectivement.

Pour des raisons pratiques de construction, il est avantageux de prévoir les quatre facettes 7 entourant le sommet O identiques aux autres.

Grâce aux zones non réfléchissantes 14 et 15 qui se croisent en O, la zone d'ombre 16 peut être plus grande dans les deux sens qu'une facette élémentaire 7, de la largeur des zones 14 et 15. Ainsi, on peut prévoir sur le bloc 8, dont la face sensible 9 est sensiblement de forme et de dimensions égales à une facette 7, une enveloppe d'isolation thermique d'épaisseur voisine de la demilargeur des zones linéaires 14 et 15.

Ainsi, grâce aux zones linéaires 14 et 15, on supprime les inconvénients des ombres portées systématiquement.

Pour optimiser encore plus la géométrie du miroir 1, la présente invention prévoit de minimiser la surface inutilisée de chaque facette réfléchissante 7 et la zone de pénombre de la tache focale.

Chaque facette 7, comme l'illustre schématiquement la figure 4, est inclinée d'un angle $\alpha$ par rapport aux rayons incidents 17, qu'elle réfléchit selon les rayons 18 avec une incidence $2\alpha$ dans le plan focal, où se trouve la face sensible 9. Si celle-ci présente une hauteur d et si le faisceau des rayons 18 couvre toute la hauteur d, la largeur l du faisceau des rayons 18 est donc égale à l = d cos $2\alpha$.

La largeur l du faisceau des rayons 18 correspond à une partie utile h de la facette 7 égale à

$$h = \frac{l}{\cos \alpha}$$

ou à

$$h = d \, \frac{\cos 2 \alpha}{\cos \alpha} .$$

Etant donné que par construction toutes les facettes 7 sont identiques et présentent une largeur voisine de celle de la face sensible 9, le rapport $\dfrac{h}{d}$ représente la proportion utile de chaque facette 7.

Or, cette proportion utile est égale $\dfrac{\cos 2 \alpha}{\cos \alpha}$ d'après le calcul précédent, de sorte qu'elle est inférieure à 1.

Pour réduire la partie inutilisée des facettes 7, on aurait donc interêt à faire tendre $\alpha$ vers 0 de façon que le rapport $\dfrac{\cos 2 \alpha}{\cos \alpha}$ tende vers 1, ce qui revient à dire que l'on devrait augmenter le plus possible la distance focale f = OF du miroir 1.

Cependant, on sait que la zone de pénombre portée par chaque facette sur la tache focale augmente quand on allonge la distance focale f = OF par rapport au côté de chaque facette.

Aussi est-il indispensable de trouver un compromis entre ces deux exigences contradictoires.

Selon une particularité importante de l'invention, on a trouvé qu'un compromis acceptable était trouvé lorsque la distance focale f = OF était égale au produit d × $\sqrt{C}$, dans lequel d représente le côté des facettes carrées 7 et C le taux de concentration de miroir 1. c'est-à-dire approximativement le nombre 4 × n × m des facettes 7.

Dans le cas où les facettes 7 sont rectangulaires et que les longueurs de leurs côtés sont respectivement $d_1$ et $d_2$, celles-ci doivent satisfaire au moins approximativement à la relation

$$f = \sqrt{d_1 \times d_2 \times C}.$$

Ainsi, grâce à ce compromis, tout en utilisant des facettes planes 7, carrées ou rectangulaires, absolument identiques entre elles, on élimine les inconvénients des miroirs à facettes planes mentionnés dans le préambule de la présente demande.

Pour pouvoir augmenter le plus possible la surface réfléchissante utile, il est avantageux que les facettes 7 présentent des dimensions à peine plus grandes que celles de la face sensible 9.

Cependant, pour les facettes éloignées de l'axe 5, les taches lumineuses correspondantes sur la face 9 sont des parallélogrammes, puisque le plan desdite facettes est oblique par rapport au plan de la face sensible 9. Aussi, pour que tous les parallélogrammes recouvrent complètement la face 9 de dimensions pratiquement égales à celles desdites facettes 7, selon une autre particularité de la présente invention, on oriente celles-ci en fonction de leur emplacement sur le miroir, en les faisant tourner autour de leur centre et dans leur plan. La figure 5 illustre, en projection sur le plan 18', 15', l'orientation des facettes 7 d'un huitième du miroir 1, les positions tournées étant fortement exagérées pour être bien apparentes.

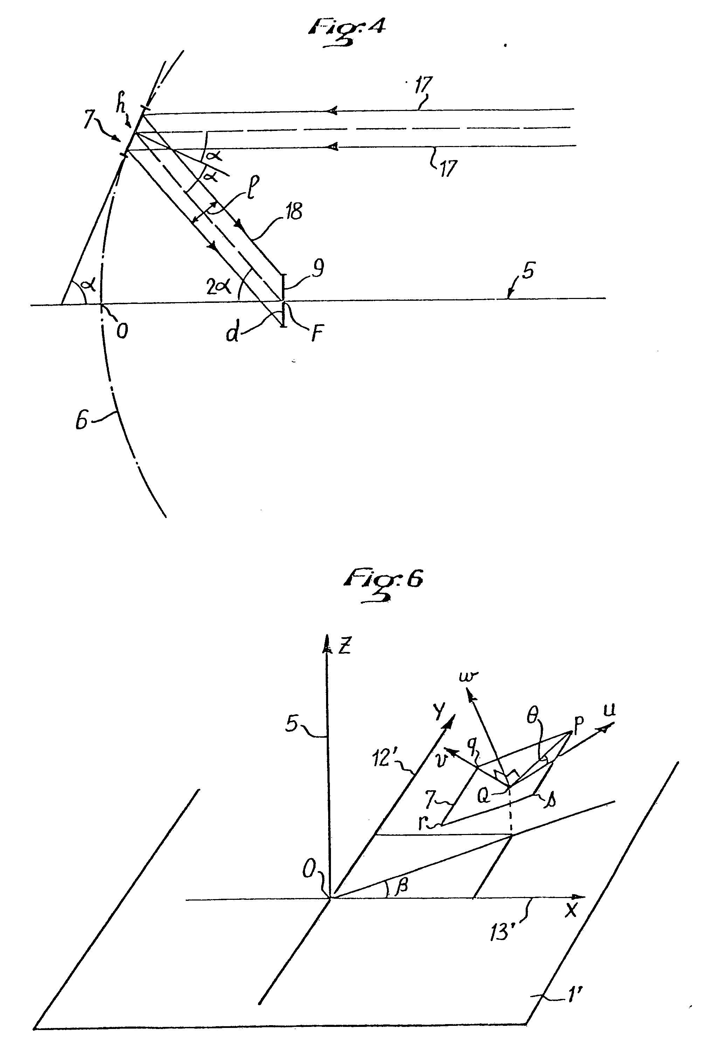

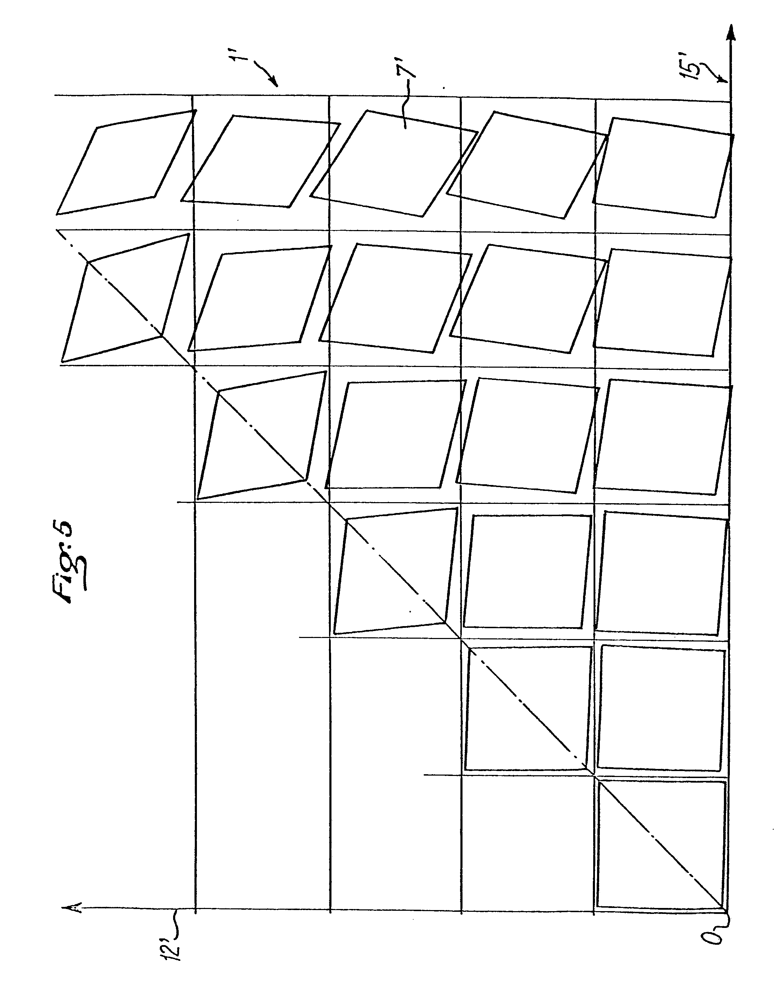

La rotation desdites facettes peut peut être effectuée empiriquement. Cependant, la Demanderesse a pu trouver des formules empiriques pour définir la rotation adéquate à donner auxdites facettes dans le cas où le miroir concave est un paraboloïde de révolution. Pour cela, on commence à déterminer deux systèmes de coordonnées OX, OY, OZ et Qu, Qv, Qw (voir la figure 6):

— le système OX, OY, OZ a pour origine le sommet O du paraboloïde, pour axe OX l'axe 13', pour axe OY l'axe 12' et pour axe OZ l'axe 5; dans ce système OX, OY, OZ, les coordonnées du centre Q d'une facette 7 sont X, Y et $\dfrac{X^2 + Y^2}{4f}$, f étant la distance focale du miroir et en supposant que la facette 7 est tangente à un paraboloïde de révolution de formule $X^2 + Y^2 = 4fZ$.

— le système Qu, Qv, Qw a pour origine le centre Q de la facette 7. L'axe Qw est normal à cette facette, tandis que l'axe Qu est tel que sa projection sur le plan XOY prolonge la projection de OQ. Enfin, Qv est orthogonal au plan uQw et parallèle au plan XOY.

Dans ces deux systèmes d'axes, une position appropriée des quatre coins p, q, r et s d'une facette 7 peut être définie par les valeurs $\theta p$, $\theta q$, $\theta r$ et $\theta s$ de l'angle $\theta$ entre l'axe Qu et les axes $Q_p$, $Q_q$, $Q_r$ et $Q_s$ respectivement.

Dans le cas d'une facette rectangulaire 7 de dimensions $d_1$ et $d_2$ (respectivement parallèles à OX et OY), la demanderesse a trouvé que ces valeurs $\theta p$, $\theta q$, $\theta r$ et $\theta s$ pouvaient être les suivantes:

$$\theta p = -\text{arc tg}\,\frac{Y}{X} - \text{arc tg}\,\frac{d_2}{d_1} - K\,\frac{X^2 + Y^2}{4f^2}\,\sin\left(4\,\text{arc tg}\,\frac{Y}{X}\right),$$

$$\theta q = -\text{arc tg}\,\frac{Y}{X} + \text{arc tg}\,\frac{d_2}{d_1} - K\,\frac{X^2 + Y^2}{4f^2}\,\sin\left(4\,\text{arc tg}\,\frac{Y}{X}\right),$$

$$\theta r = -\text{arc tg}\,\frac{Y}{X} - \text{arc tg}\,\frac{d_2}{d_1} + 180° + K\,\frac{X^2 + Y^2}{4f^2}\,\sin\left(4\,\text{arc tg}\,\frac{Y}{X}\right),$$

$$\theta s = -\text{arc tg}\,\frac{Y}{X} + \text{arc tg}\,\frac{d_2}{d_1} + 180° + K\,\frac{X^2 + Y^2}{4f^2}\,\sin\left(4\,\text{arc tg}\,\frac{Y}{X}\right)$$

dans lesquels K représente l'angle dont on ferait tourner un miroir situé à une distance de l'axe focal égale à la distance focale.

Si tous les angles de ces formules sont exprimés en degrés, il en est de même de K. On a trouvé que des valeurs de K voisines de 25° donnaient de bons résultats.

Si les facettes 7 sont carrées, les formules ci-dessus restent valables en faisant $d_1 = d_2$.

## Revendications

1. Miroir concave (1) qui, d'une part, est destiné à fournir, lorsqu'il est pointé vers une source lumineuse éloignée, tel que le soleil, une tache focale ou quasi-focale utile de forme approximativement carrée ou rectangulaire et de dimensions prédéterminées, ladite tache utile étant centrée sur l'axe (5) dudit miroir, et dont, d'autre part, la surface réfléchissante est constituée d'une pluralité de facettes planes indentiques (7) dont la forme et les dimensions correspondant à celles de ladite tache utile et qui sont disposées en lignes et en colonnes, de sorte que la section, dans le plan de la tache utile, du faisceau réfléchi (18) provenant de chaque facette plane recouvre totalement ladite tache utile, caractérisé en ce que les deux dimensions desdites facettes (7) sont telles que la racine carrée de leur produit est au moins approximativement égale au rapport de la distance focale du miroir (1) et de la racine carrée du taux de concentration de celui-ci.

2. Miroir concave selon la revendication 1, caractérisé en ce que lesdites facettes (7) sont carrées.

3. Miroir concave selon l'une des revendications 1 ou 2, dans lequel chaque facette (7) présente des dimensions sensiblement égales à celles de ladite tache utile, caractérisé en ce que dans les lignes et les colonnes les facettes individuelles (7) sont tournées, dans leur plan et autour de leur centre, pour que la section, dans le plan de ladite tache utile, du faisceau (18) réfléchi par charcune d'elles recouvre totalement ladite tache utile, l'amplitude de cette rotation étant d'autant plus grande que le facette est plus éloignée du sommet du miroir.

4. Miroir concave selon la revendication 3, du type paraboloïde de révolution dans lequel on établit un premier système de coordonnées OX, OY, OZ tel que O est le sommet du miroir, OZ l'axe du miroir, OX la projection, sur le plan orthogonal en O à l'axe OZ, de l'axe des lignes de miroirs et OY la projection sur le même plan de l'axe des colonnes desdits miroirs, ainsi qu'un second système de coordonnées Qu, Qv, Qw, tel que Q est le centre d'une facette ayant les coordonnées X et Y dans le premier système, Qw la normale en Q à la facette, Qu l'axe du plan de la facette se projetant sur le plan XOY en alignement avec la projection sur le même plan XOY de OQ et Qv étant orthogonal au plan uQw, caractérisé en ce que, dans ces deux systèmes de coordonnées, les positions de chacun des sommets (p, q, r, s) de la facette (7) sont définies par la valeur des angles $\theta$p, $\theta$q, $\theta$r et $\theta$s, de sommet Q et d'axe d'origine Qu, tel que

$$\theta p = -\arctan \frac{Y}{X} - \arctan \frac{d_2}{d_1} - K\frac{X^2+Y^2}{4f^2} \sin\left(4\arctan\frac{Y}{X}\right),$$

$$\theta q = -\arctan \frac{Y}{X} + \arctan \frac{d_2}{d_1} - K\frac{X^2+Y^2}{4f^2} \sin\left(4\arctan\frac{Y}{X}\right),$$

$$\theta r = -\arctan \frac{Y}{X} - \arctan \frac{d_2}{d_1} + 180° + K\frac{X^2+Y^2}{4f^2} \sin\left(4\arctan\frac{Y}{X}\right),$$

$$\theta s = -\arctan \frac{Y}{X} + \arctan \frac{d_2}{d_1} + 180° + K\frac{X^2+Y^2}{4f^2} \sin\left(4\arctan\frac{Y}{X}\right)$$

dans lesquelles, f est la distance focale du miroir, K représente l'angle dont on ferait un miroir situé à une distance de l'axe focal égale à la distance focale et $d_1$ et $d_2$ sont les longueurs des facettes (7) respectivement sensiblement parallèles aux axes OY et OY.

5. Miroir concave selon la revendication 4, caractérisé en ce que, si les différents angles apparaissant dans les formules sont exprimés en degrés, K est approximativement égal à 25°.

6. Miroir concave selon l'une quelconque des revendications 1 à 5, caractérisé en ce que les différentes facettes planes (7) sont tangentes à la surface d'un paraboloïde de révolution.

7. Miroir concave selon l'une quelconque des revendications 1 à 6, caractérisé en ce que son contour extérieur est un carré ou un rectangle curviligne.

8. Générateur solaire comportant d'une part un concentrateur solaire (1) et d'autre part un agencement de cellules photovoltaïques (8), caractérisé en ce que ledit concentrateur solaire est constitué par le miroir (1) spécifié sous l'une quelconque des revendications 1 à 7, et en ce que la face sensible (9) dudit agencement (8) de cellules photovoltaïques correspond au moins approximativement en forme et en dimensions à ladite tache focale ou quasi-focale utile et est mise en superposition avec celle-ci.

9. Générateur solaire selon la revendication 7, dans lequel l'agencement des cellules photovoltaïques (8) est supporté par des bras (10) prenant appui à la périphérie du miroir (1), caractérisé en ce que les zones (14, 15) du miroir (1) correspondant aux zones d'ombre portées par les bras (10) de support de l'agencement de cellules photovoltaïques (8), et/ou par ledit agencement (8) lorsque l'axe (5) du miroir est pointé vers le soleil, ne sont pas réfléchissantes.

10. Générateur solaire selon la revendication 9, comportant quatre bras (10) de support de l'agencement de cellules photovoltaïques (8), définissant deux plans axiaux orthogonaux entre eux, caractérisé en ce que lesdites facettes réfléchissantes (7) sont réparties en quatre groupes identiques séparés les uns des autres par les branches d'une croix (14, 15) non réfléchissantes, lesdites branches étant respectivement parallèles aux lignes et aux colonnes de cellules photovoltaïques.

11. Générateur solaire selon la revendication 9, caractérisé en ce que l'ombre (16) de l'agencement de cellules photovoltaïques (8) sur le miroir (1) recouvre la partie centrale de la croix (14, 15) et les quatre quarts centraux des quatres facettes (7) entourant directement le sommet (0) du miroir (1).

## Patentansprüche

1. Hohlspiegel (1), der ein einerseits bei Ausrichtung auf eine entfernte Leuchtquelle wie die Sonne einen Nutzbrennpunkt bzw. Fleck oder Quasi-Brennpunkt von beispielshalber quadratischer oder rechteckiger Form sowie von vorbestimmter Abmessung und mit Zentrierung auf die Achse (5) des Spiegels, und andererseits dessen Reflexionsfläche mehrere baugleiche flache Facetten (7) aufweist, deren Form und Abmessungen dem Nutzbrennpunkt entsprechen und die in Reihen und Spalten derart angeordnet sind, daß der Schnitt in der Brennpunktebene des von jeder Facette stammenden reflektierten Bündels (18) den Brennpunkt völlig abdeckt, dadurch gekennzeichnet, daß die beiden Abmessungen der Facetten (7) derart sind, daß die Quadratwurzel ihres Produkts zumindest annähernd gleich ist zum Verhältnis des Brennpunktabstandes des Spiegels (1) und der Quadratwurzel seines Sammelverhältnisses.

2. Hohlspiegel nach Anspruch 1, dadurch gekennzeichnet, daß die Facetten (7) quadratisch ausgebildet sind.

3. Hohlspiegel nach den Ansprüchen 1 oder 2, in dem jede Facette (7) Abmessungen besitzt, die allgemein gleich sind denen des Nutzbrennpunkts, dadurch gekennzeichnet, daß die Reihen und Spalten der einzelnen Facetten (7) in ihrer Ebene um ihren Mittelpunkt gedreht sind, so daß der Schnitt, in der Ebene des Nutzbrennpunkts, des reflektierenden Bündels (18) für eine jede von ihnen den Nutzbrennpunkt völlig abdeckt, wobei die Amplitude der Drehung um so größer ist, wie die Facette vom Spiegelscheitel weiter entfernt ist.

4. Hohlspiegel nach Anspruch 3 ausgebildet als Rotationsparaboloidsspiegel, in dem ein erstes Koordinatensystem OX, OY, OZ, so daß O der Scheitel des Spiegels, OZ die Achse des Spiegels, OX die auf der Orthogonalebene von O zur Achse OZ liegende Projektion der Achse der Spiegelreihen und OY die auf derselben Ebene liegende Projektion der Achse der Spiegelspalten ist, und ein zweites Koordinatensystem Qu, Qv, Qw erstellt wird, so daß Q die Mitte einer Facette mit den Koordinaten X und Y im ersten System, Qw die Normale von Q zur Facette, Qu die Achse der sich auf die Ebene XOY in Ausrichtung mit der Projektion auf dieselbe Ebene XOY von OQ projezierenden Ebene der Facette, und Qv orthogonal zur Ebene uQw ist, dadurch gekennzeichnet, daß in beiden Koordinatensystemen die Positionen jedes Scheitels (p, q, r, s) der Facette (7) definiert werden durch die Größe der Winkel $\theta$, $\theta q$, $\theta r$ und $\theta s$ von Scheitel Q und Ausgangsachse Qu, so daß

$$\theta p = -\text{arc tg}\ \frac{Y}{X} - \text{arc tg}\ \frac{d_2}{d_1} - K\ \frac{X^2+Y^2}{4\,f^2}\ \sin\left(4\ \text{arc tg}\ \frac{Y}{X}\right),$$

$$\theta q = -\text{arc tg}\ \frac{Y}{X} + \text{arc tg}\ \frac{d_2}{d_1} - K\ \frac{X^2+Y^2}{4\,f^2}\ \sin\left(4\ \text{arc tg}\ \frac{Y}{X}\right),$$

$$\theta r = -\text{arc tg}\ \frac{Y}{X} - \text{arc tg}\ \frac{d_2}{d_1} + 180° + K\ \frac{X^2+Y^2}{4\,f^2}\ \sin\left(4\ \text{arc tg}\ \frac{Y}{X}\right),$$

$$\theta s = -\text{arc tg}\ \frac{Y}{X} + \text{arc tg}\ \frac{d_2}{d_1} + 180° + K\ \frac{X^2+Y^2}{4\,f^2}\ \sin\left(4\ \text{arc tg}\ \frac{Y}{X}\right)$$

wobei f der Brennpunktabstand des Spiegels ist, K den Winkel darstellt, um den ein in einer von der Brennachse zum Brennpunktabstand gleichen Entfernung liegender Spiegel gedreht wird, und $d_1$ und $d_2$ die Längen der allgemein parallel zu den Achsen OY bzw. OZ liegenden Facetten sind.

5. Hohlspiegel nach Anspruch 4, dadurch gekennzeichnet, daß bei den verschiedenen in den Formeln erscheinenden Winkeln in Grad ausgedrückt der Winkel K bei annähernd 25° liegt.

6. Hohlspiegel nach einem der Ansprüche 1 bis 5, dadurch gekennzeichnet, daß die verschiedenen ebenen Facetten (7) tangential zur Oberfläche eines Rotationsparaboloids liegen.

7. Hohlspiegel nach einem der Ansprüche 1 bis 6, dadurch gekennzeichnet, daß der Außenumriß ein gekrümmtes Quadrat oder Rechteck ist.

8. Sonnengenerator mit einerseits einem Strahlungsbündler (1) und andererseits einer Anordnung von photo-voltaischen Zellen (8), dadurch gekennzeichnet, daß der Strahlungsbündler aus einem Spiegel (1) nach einem der Ansprüche 1 bis 7 besteht und daß die ansprechende Fläche (9) der Anordnung (8) der photo-voltaischen Zellen zumindest annähernd in der Form und in den Abmessungen dem Nutzbrennpunkt oder Quasi-Brennpunkt entspricht und mit diesem zur Überlagerung gebracht wird.

9. Sonnengenerator nach Anspruch 7, in dem die Photozellenanordnung (8) von den Schenkeln (10) getragen wird, die auf dem Umfang des Spiegels (1) sitzen, dadurch gekennzeichnet, daß die Zonen (14, 15) des Spiegels, die den von den Schenkeln (10) der Photozellenanordnung getragenen beschatteten Zonen bzw. den Zonen entsprechen, die beim Richten der Spiegelachse zur Sonne durch die Anordnung (8) entstehen, nicht reflektierend sind.

10. Sonnengenerator nach Anspruch 9 mit vier Tragschenkeln der Photozellenanordnung (8), durch die zwei zueinander orthogonal stehende Axialebenen begrenzt werden, dadurch gekennzeichnet, daß die reflektierenden Facetten (7) in vier baugleiche Gruppen aufgeteilt sind, die durch die nicht reflektierenden Zweige eines Kreuzes (14, 15) von einander getrennt sind, die parallel zu den Reihen bzw. Spalten der Photozellen liegen.

11. Sonnengenerator nach Anspruch 9, dadurch gekennzeichnet, daß der Schatten (16) der Photozellenanordnung (8) auf dem Spiegel (1) den Mittelteil des Kreuzes (14, 15) und die mittleren vier Viertel der vier Facetten (7) bedeckt, die unmittelbar um den Scheitel des Spiegels herumliegen.


## Claims

1. Concave mirror (1) which, on the one hand, is adapted to furnish, when it is aimed towards a remote light source such as the sun, a useful focal or quasi-focal spot of at least approximately square or rectangular form and of predetermined dimensions, said useful spot being centred on the axis (5) of said mirror, and of which, on the other hand, the reflecting surface is constituted by a plurality of identical plane facets (7) whose shape and dimensions correspond to those of said useful spot and which are disposed in lines and in columns, so that the section, in the plane of the useful spot, of the reflected beam (18) coming from each plane facet totally covers said useful spot, characterized in that the two dimensions of said facets (7) are such that the square root of their product is at least approximately equal to the ratio of the focal distance of the mirror (1) and of the square root of the rate of concentration of said mirror.

2. The concave mirror of Claim 1, characterized in that said facets (7) are square.

3. The concave mirror of either one of Claims 1 or 2, in which each facet (7) presents dimensions substantially equal to those of said useful spot, characterized in that, in the lines and columns, the individual facets (7) are rotated, in their plane and about their centre, so that the section, in the plane of the useful spot, of the beam (18) reflected by each of them totally covers said useful spot, the amplitude of this rotation being greater as the facets is more remote from the vertex of the mirror.

4. The concave mirror of Claim 3, of the paraboloid of revolution type in which a first system of coordinates OX, OY, OZ is established such that O is the vertex of the mirror, OZ the axis of the mirror, OX the projection, on the plane orthogonal at O to axis OZ, of the axis of the lines of mirrors and OY the projection on the same plane of the axis of the columns of said mirrors, as well as a second system of coordinates Qu, Qv, Qw, such that Q is the centre of a facet having the coordinates X and Y in the first system, Qw the normal at Q to the facet, Qu the axis of the plane of the facet projecting on the plane XOY in alignment with the projection on the same plane XOY of OQ and Qv being orthogonal to the plane uQw, characterized in that, in these two systems of coordinates, the positions of each of the corners (p, q, r, s) of the facet (7) are defined by the value of the angles $\theta p$, $\theta q$, $\theta r$ and $\theta s$, of vertex Q and of axis of origin Qu, such that

$$\theta p = -\operatorname{arc} \operatorname{tg} \frac{Y}{X} - \operatorname{arc} \operatorname{tg} \frac{d_2}{d_1} - K \frac{X^2 + Y^2}{4 f^2} \sin \left( 4 \operatorname{arc} \operatorname{tg} \frac{Y}{X} \right),$$

$$\theta q = -\operatorname{arc} \operatorname{tg} \frac{Y}{X} + \operatorname{arc} \operatorname{tg} \frac{d_2}{d_1} - K \frac{X^2 + Y^2}{4 f^2} \sin \left( 4 \operatorname{arc} \operatorname{tg} \frac{Y}{X} \right),$$

$$\theta r = -\operatorname{arc} \operatorname{tg} \frac{Y}{X} - \operatorname{arc} \operatorname{tg} \frac{d_2}{d_1} + 180° + K \frac{X^2 + Y^2}{4 f^2} \sin \left( 4 \operatorname{arc} \operatorname{tg} \frac{Y}{X} \right),$$

$$\theta s = -\operatorname{arc} \operatorname{tg} \frac{Y}{X} + \operatorname{arc} \operatorname{tg} \frac{d_2}{d_1} + 180° + K \frac{X^2 + Y^2}{4 f^2} \sin \left( 4 \operatorname{arc} \operatorname{tg} \frac{Y}{X} \right)$$

in which f is the focal distance of the mirror, K represents the angle through which a mirror located at a distance from the focal axis equal to the focal distance would be rotated, and $d_1$ and $d_2$ are the lengths of the facets (7) respectively substantially parallel to axes OX and OY.

5. The concave mirror of Claim 4, characterized in that if the different angles appearing in the formulae are expressed in degrees, K is approximately equal to 25°.

6. The concave mirror of one of Claims 1 to 5, characterized in that the different plane facets (7) are tangential to the surface of a paraboloid of revolution.

7. The concave mirror of one of Claims 1 to 6, characterized in that its outer contour is a curvilinear square or rectangle.

8. A solar generator comprising, on the one hand a solar concentrator (1) and, on the other hand, an arrangement of photovoltaic cells (8), characterized in that said solar concentrator is constituted by the mirror (1) of anyone of Claims 1 to 7, and the sensitive face (9) of said arrangement (8) of photovoltaic cells corresponds at least approximately in shape and in dimensions to said useful focal or quasi-focal spot and is superposed thereon.

9. The solar generator of Claim 7, in which the photovoltaic cell arrangement (8) is supported by arms (10) abutting on the periphery of the mirror 1, characterized in that the zones (14, 15) of the mirror 1 corresponding to the zones of shadow cast by the arms (10) supporting the photovoltaic cell arrangement (8), and/or by said arrangement (8) when the axis (5) of the mirror is aimed towards the sun, are not reflecting.

10. The solar generator of Claim 9, comprising four arms (10) for supporting the photovoltaic cell arrangement (8), defining two axial planes at right angles to each other, characterized in that said reflecting facets (7) are distributed in four identical groups separated from one an other by the non-reflecting arms of a cross (14, 15), said arms being respectively parallel to the lines and columns of photovoltaic cells.

11. The solar generator of Claim 9, wherein the shadow (16) of the photovoltaic cell arrangement (8) on the mirror (1) covers the central part of the cross (14, 15) and the four central quarters of the four facets (7) directly surrounding the vertex (10) of the mirror (1).

Fig. 1

Fig. 2

## Fig:3

0 059 653

*Fig. 4*

*Fig. 6*

Fig. 5

0 059 653